# DEMANDE DE BREVET EUROPEEN

(11) **EP 0 678 924 A1**
(43) Date de publication de la demande: **25.10.1995**
(21) Numéro de dépôt: 95400845.4
(22) Date de dépôt: 14.04.1995
(51) Int. Cl.: H01L 41/04, H01L 41/18, H01L 41/193

(54) **Dispositif piézo-sensible à polarisation variable**

(30) Priorité: 22.04.1994 FR 9404853; 17.11.1994 FR 9413743
(71) Demandeur: ETAT FRANCAIS Représenté par le délégué général pour l'armement, F-00460 Armées (FR)
(72) Inventeur: Boisrayon, Michel, F-83330 Le Beausset (FR); Scarpitta, Alain, F-83200 Toulon (FR); Meyer, Luc, F-83130 La Garde (FR)

(57) **Abrégé**

L'invention concerne le domaine de la piézo-électricité et a plus particulièrement pour objet un dispositif piézo-sensible à polarisation variable et réglable, caractérisé en ce qu'il comporte notamment un ou plusieurs matériaux piézo-sensibles (6) et des moyens (9) permettant d'appliquer, à ce ou ces matériaux, une tension de polarisation U, continue ou alternative, ces moyens comportant une source (10) de tension, un amplificateur polarisateur (11) et des électrodes (12,13).

Un tel dispositif peut, par exemple, être utilisé dans les transducteurs électromécaniques mis en oeuvre dans les antennes sonar.

## Description

L'invention concerne le domaine de la piézo-électricité et a plus particulièrement pour objet un dispositif piézo-sensible à polarisation variable et réglable. Un tel dispositif peut, par exemple, être utilisé dans les capteurs, de type transducteurs électromécaniques, mis en oeuvre dans les antennes sonar. Ces transducteurs peuvent être des hydrophones, des accéléromètres, des capteurs de pression hydrostatique, de déformation, de force ou de température ou des systèmes complexes pouvant associer ces différentes fonctions. Ces dispositifs peuvent également être utilisés, dans l'air, dans des microphones, des accéléromètres, des claviers de téléscripteurs ou d'ordinateurs, des détecteurs de chaleur ou des revêtements piézochromes.

Dans tout le texte, il faut entendre par matériau piézo-sensible, un dispositif sensible à la pression et présentant des propriétés piézo-électriques et/ou piézo-résistives et/ou piézo-polaires. Aussi, un dispositif piézo-sensible sera un dispositif utilisant un tel matériau.

De plus le mot particules sera utilisé comme terme générique et rassemblant notamment les poudres, les fibres et les fragments d'objets ou de matériaux.

Il existe de nombreux matériaux piézo-électriques, notamment composites, utilisés dans l'industrie.

Ainsi, le brevet US2420864 décrit un procédé de fabrication d'un matériau piézo-électrique comportant une matrice en matière plastique et un monocristal piézo-électrique.

Les matières plastiques citées sont les celluloïdes, les acétates de celluloses, les caoutchoucs chlorés, les phénol-formaldéhydes, les résines phénols-furfurol, les acrylates, les méthacrylates et les polystyrènes, tandis que les monocristaux sont choisis parmi le sel de Seignette, la tourmaline, le saccharose et l'acide tartrique.

Ces matériaux sont conçus pour être utilisés uniquement en mode hydrostatique, c'est-à-dire en soumettant toute leur surface à la pression acoustique incidente. Toutefois, ces monocristaux ont de très faibles constantes hydrostatiques et sont donc peu efficaces.

Les monocristaux ont été progressivement remplacés par des céramiques de perovskistes, et plus particulièrement par du titano-zirconate de plomb (PZT) ou du titanate de baryum, pour la mise en oeuvre de fortes puissances d'émission. Cependant, à la réception, leur constante hydrostatique est inférieure à celle de monocristaux tel le sulfate de lithium. Aussi, leur utilisation est limitée aux modes de compression privilégiés appartenant aux types 33,31 ou 32.

Le brevet US74233485 décrit un matériau piézo-électrique composite constitué de poudre de céramique et de polymère. Cette poudre est un mélange fritté de titanate de plomb et d'oxyde double de fer et de bismuth dont la taille moyenne des grains est de 5 microns tandis que la part pondérale de l'oxyde double de fer et de bismuth est comprise entre 50 à 80%.

Le brevet US4407054 décrit un matériau piézo-électrique composite composé d'un pré polymère tel un mélange d'huile de ricin et d'isocyanate de ricinoléate, et un matériau piézo-électrique tel le quartz, le PZT, la tourmaline, l'acide tartrique ou le sulfate de lithium.

Enfin, le brevet US4868856 décrit un matériau piézo-électrique composite constitué d'un polymère réalisé à base de polyuréthanne et d'un matériau piézo-électrique tel l'acide tartrique, un monosaccharide, un disaccharide ou un carboxylate.

Il est aussi connu que les produits appelés "Electrets", obtenus en soumettant des cires, rendues liquides par chauffage, à un fort champ électrique au cours de leur phase de refroidissement, présentent des propriétés pyroélectriques et piézo-électriques prononcées et permanentes.

Tous ces matériaux présentent de nombreux inconvénients, notamment lorsqu'ils sont utilisés dans des hydrophones. En effet, leur polarisation ou, d'une manière plus générale, leurs propriétés piézo-électriques, sont figées à l'issue de leur fabrication et, de ce fait, leur mode de fonctionnement est unique ou spécialisé (mode hydrostatique, mode 33, 31, 15 etc.). A titre d'exemple, un composite obtenu en mélangeant des grains d'acide tartrique ou de sulfate de lithium avec une résine non encore polymérisée, puis en polarisant les grains par l'un des procédés décrits dans les brevets antérieurs ne pourra être utilisé qu'en mode hydrostatique, et ses propriétés piézo-électriques sont, en principe, invariables ou varient lentement dans le temps.

L'un des buts de la présente invention est d'obtenir en revanche un matériau dont la polarisation et, par conséquent, les propriétés piézo-électriques, ou plus généralement piézo-sensibles, peuvent varier à volonté par l'application d'un champ électrique lorsque le transducteur comprenant ce matériau, ou l'antenne comprenant les transducteurs utilisant ce matériau, est en fonctionnement. Ainsi lorsque, par exemple, une antenne présente une panne, un matériau selon l'invention permet d'y pallier en intervenant dans l'antenne. Il n'est donc pas nécessaire de procéder à ces corrections au niveau du récepteur, ce qui n'est pas toujours possible, ou ce qui augmente le coût dudit récepteur.

Les antennes peuvent également être soumises à des bruits gênants ou à des signaux parasites permanents ou transitoires. L'invention permet d'éliminer ou de réduire ces bruits gênants ou ces signaux parasites en modifiant de manière directe les caractéristiques piézo-sensibles des capteurs élémentaires.

Pour cela, un dispositif selon l'invention comporte un ou plusieurs matériaux piézo-sensibles et des moyens permettant d'appliquer, à ce ou ces matériaux, une tension de polarisation. Cette tension est appelée U dans la suite. Selon une caractéristique privilégiée, lesdits moyens comportent des moyens aptes à régler la valeur de la tension U de polarisation.

En outre la tension U appliquée au matériau piézo-sensible peut être continue ou alternative.

Selon une caractéristique additionnelle, lesdits moyens comportent une source de tension, un amplificateur polarisateur et des électrodes.

Selon une caractéristique privilégiée, ces électrodes sont du type peigne.

Selon une autre caractéristique, le matériau piézo-sensible comporte des particules, telles des fibres, des poudres ou des fragments d'objets ou de matériaux, qui sont, suivant les cas, piézo-électriques, faiblement piézo-électriques, voire non piézo-électriques.

Selon une autre caractéristique, la taille des particules est comprise entre 5.10⁻⁹m et 5.10⁻³m.

Selon une caractéristique préférentielle, ces particules sont de taille sensiblement identique.

Selon une caractéristique particulière, ces particules sont issues, en totalité ou en partie, d'au moins un matériau biologique ou de feuilles ou de plaques de matières plastiques piézo-électriques pré polarisées dans le sens de l'épaisseur ou non pré polarisées, ou de microcristaux.

Selon une caractéristique préférentielle, le matériau biologique est choisi parmi des oligosaccharides, des homopolysaccharides, des hétéropolysaccharides, des glycosaminoglycanes, des protéoglycanes, des terpènes, des stéroïdes, des acides aminés, des oligopeptides et des polypeptides, des protéines, des nucléotides, des acides nucléiques, de l'urée ou des soies naturelles.

Selon une autre caractéristique, ces particules sont issues, en totalité ou en partie, des microcristaux ou des fibres de tartrate d'ammonium, de tartrate de potassium, de tartrate de diamine éthylène, de tartrate de dipotassium, de chlorate de sodium, de bromate de sodium, d'hexahydrate de sulfate de nickel, d'acide iodique, de benzophénone, de gallate de lithium hydraté, ou déshydraté, de polyvinyledifluoridène, de chrlorure de polyvinyle, de copolymère d'acétate de vinyle et de cyanide de vinylidène, de copolymère de vinylidène et de trifluoréthylène, du fluorure de polyvinyle, de nylon, de polyacrylonitrile, du polyparaxylylène, de polybichlorométhyloxétane, de polyamide aromatique, de polysulfone, de cyanoéthylcellulose, de monosaccharides, de disaccharides, de brushite, de monétite ou de sels d'acide carboxylique.

Selon une variante de mise en oeuvre de l'invention, le matériau piézo-sensible est constitué d'un agglomérat de particules.

Selon une caractéristique additionnelle, les particules constitutives de cet agglomérat sont issues, en totalité ou en partie, d'un matériau non piézo-électrique ou faiblement piézo-électrique, tel que les polystyrènes, polysulfones, polycarbonates, polypropylènes, polyéthylène, téréphtalates de polyéthylène, oxydes de polyphénylène, esters de polyacrylate, esters de polyméthacrylate, chlorures de polyvinyle, polyvinylidènes, polymères d'acrylonitrile, polymère de méthacrylonitriles, acétate de polyvinyle, celluloïdes, acétates de cellulose, polyvinylepyrrolidones, polymères cellulosiques, phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, les copolymères de vinylidène et de trifluorèthylène, les élastomères de polyuréthanne ou les polyvinyles carbazone.

Selon une autre variante de réalisation, le matériau piézo-sensible est constitué d'une matrice de polymère ou de produit organique diélectrique, non piézo-électrique ou faiblement piézo-électrique, et de particules piézo-électriques.

Selon une réalisation préférentielle, la matrice de polymère ou le produit organique diélectrique, non piézo-électrique ou faiblement piézo-électrique est choisi parmi les polystyrènes, polysulfones, polycarbonates, polypropylènes, polyéthylène, téréphtalates de polyéthylène, oxydes de polyphénylène, les elastomères de polyuréthanne, les polyvinylecarbazols et les fluorures de polyvinylidène, les esters de polyacrylate ou de de polyméthacrylate, les chlorures de polyvinyle, polyvinylidènes, les polymères d'acrylonitrile ou de méthacrylonitriles, les acétates de polyvinyle, celluloïdes, acétates de cellulose, polyvinylepyrrolidones, polymères cellulosiques, phénol-formaldéhydes, les résines phénols-furfural, les polymères solubles de phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, ou les copolymères de vinylidène et de trifluorèthylène.

Un autre inconvénient des matériaux, décrits dans les brevets antérieurs et comportant des particules piézo-électriques réside dans le fait que ces dernières ont des tailles qui sont supérieures au micron (10⁻⁶ m), la dispersion de taille allant de quelques microns à plusieurs centaines de microns. Or, l'une des conditions permettant d'obtenir un composite de bonne qualité réside dans la régularité de forme et de taille des particules, comme il est expliqué dans le brevet US 4,407,054 par exemple.

L'une des façons d'obtenir des tailles et des formes régulières consiste à découper dans le matériau d'origine, polarisé ou non, des macro-particules de tailles supérieures au mm, le mot taille désignant la plus grande des dimensions d'une particule. On peut, par exemple, découper, à l'aide d'un massicot, des feuilles ou des plaques de matières plastiques piézo-électriques pré polarisées dans le sens de l'épaisseur ou non pré polarisées tels que du polyvinyledifluoridène ou PVF2, du chrlorure de polyvinyle, des copolymères d'acétate de vinyle et de cyanide de vinylidène, des copolymères de vinylidène et de trifluoréthylène, du fluorure de polyvinyle, des Nylon, des polyacrylonitriles, du polyparaxylylène, du polybichlorométhyloxétane, des polyamides aromatiques, des polysulfones ou des polypeptides synthétiques d'alkyglutamate et d'arylglutamate), *ou sectionner des fils* (de copolymères par exemple) polarisés radialement. Ce procédé, bien que ne conduisant pas nécessairement à une réduction de coût, peut être mis en oeuvre dans le cadre de la présente invention.

Une deuxième méthode consiste à utiliser des matériaux biologiques présentant des propriétés piézo-électriques et que l'on peut éventuellement diviser par ultra-centrifugation différentielle, cette technique permettant d'obtenir des particules ayant une taille de l'ordre 5.10⁻⁹m. Les matériaux biologiques intéressants du point de vue piézo-électrique peuvent être des oligosaccharides (raffinose et stachyose végétales par exemple), des homopolysaccharides (cellulose, chitine, chitosane, par exemple), des hétéropolysaccharides (glucomannanes et galactomannanes par exemple), des glycosaminoglycanes (appelés aussi glycosamino-glycurono-glycanes ou mycopolysaccharides acides), des protéoglycanes, des terpènes (monohydrate de terpène par exemple), des stéroïdes (cholestérol et stérols poly-γbenzylglutamate, copolymères de βhydroxybutyrate et de β hydroxyvalérate, poly-βhydroxybutyrate par exemple), des protéines (kératines α et β, tropocollagènes et collagènes de types I, II, III, IV, V, myoglobines et hémoglobines par exemple), des nucléotides, des acides nucléiques (acide désoxyribonucléique ou acide ribonucléique), de l'urée ou des soies naturelles.

Une troisième méthode peut être employée lorsqu'on synthétise des monocristaux d'origine minérale comme la brushite ou le sel de Seignette. Elle consiste à accélérer le processus de cristallisation en agitant la solution par vibration ou par ultrasons. On détermine ainsi la formation de cristallides de taille beaucoup plus faible que celle des particules obtenues généralement par des procédés ordinaires.

Tous les composés piézo-électriques, faiblement piézo-électriques ou non piézo-électriques, chimiques ou biologiques, précités peuvent, notamment après compactage des particules et formation d'un agglomérat, être utilisés, suivant les cas, comme matériau piézo-électrique à polarisation variable, ou comme matériau piézorésistif ou comme matériau piézopolaire dans le cadre de la présente invention.

Il est clair aussi, que l'on peut réaliser, dans le cadre de cette invention, des matériaux piézo-sensibles constitués par des mélanges de particules différentes, par exemple, des particules de brushite associées à des particules de collagène et à de la résine silicone. Ces mélanges peuvent être utilisés sans application d'une pression statique ou après application d'une pression statique suffisamment élevée pour obtenir un matériau compact. De plus, on peut utiliser simultanément des particules appartenant à la première catégorie (taille comprise entre 1 mm et 5 mm) et à la deuxième catégorie (taille inférieure à quelques centaines de microns) ; mais, dans la plupart des cas, il est préférable d'utiliser des particules différentes appartenant à la même catégorie.

On peut ainsi obtenir un matériau bimode ou polymode à polarisation variable, c'est-à-dire un matériau qui, suivant la nature de ses composants peut être, par exemple, utilisé soit en mode 33, soit en mode hydrostatique, le mode de fonctionnement dépendant de la façon dont les contraintes mécaniques sont apppliquées au matériau et de la direction du champ électrique appliqué audit matériau.

En utilisant au moins deux dispositifs selon l'invention, on peut obtenir un capteur dans lequel les matériaux piézo-électriques à polarisation variable associés fonctionnent selon des modes différents (hydrostatique, compression, cisaillement , flexion), les champs de polarisation continue ou alternative appliqués pour faire apparaître la sensibilité desdits matériaux et correspondant aux tensions de polarisation continue ou alternative, ayant soit des directions identiques, soit des directions différentes suivant les modes de fonctionnement des matériaux considérés.

D'autres avantages et caractéristiques de la présente invention apparaîtront dans la description de variantes de réalisation appliquées principalement à des hydrophones, en regard des figures annexées parmi lesquelles les figures 1a à 1f présente des schémas d'agencement, utilisables dans le cadre de l'invention, de matériaux piézo-sensibles à l'intérieur d'un boîtier d'hydrophone.
- les figures 2a à 2d présentent des moyens d'application, selon l'invention, d'une tension de polarisation U aux matériaux piézo-électriques figurant sur la figure 1f.
- la figure 3 présente un schéma d'un moule servant à la fabrication d'un matériau piézo-électrique selon l'invention,.
- la figure 4 montre un schéma des moyens de raccordement électriques des électrodes,
- la figure 5 présente un schéma général des moyens constitutifs de l'invention,
- les courbes de la figure 6 présentent l'évolution de la sensibilité d'un hydrophone selon la variante en fonction de la fréquence et de la tension de polarisation.
- la figure 7 montre un schéma d'une variante de réalisation d'un dispositif selon l'invention,
- la figure 8 présente un outillage permettant de réaliser un matériau piézo-sensible selon l'invention,
- les courbes de la figure 9 présentent l'évolution de la sensibilité d'un hydrophone selon la variante en fonction de la fréquence et de la tension de polarisation.

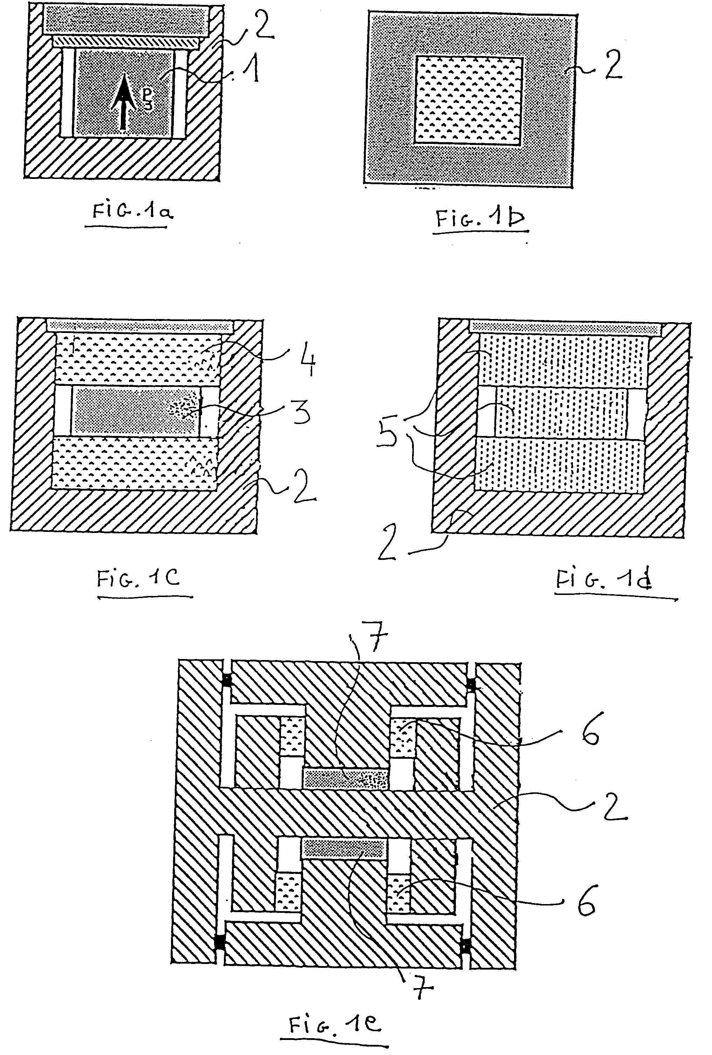

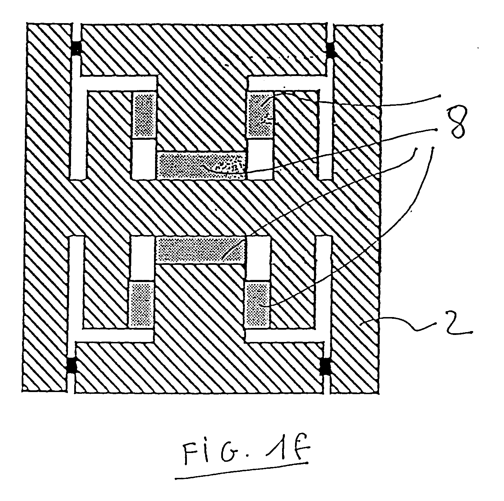

La figure 1a montre le schéma d'un hydrophone dont l'élément sensible est un disque ferroélectrique 1 présentant une forte polarisation dans le sens de l'épaisseur, c'est-à-dire dans une direction perpendiculaire à ses faces. Si le matériau est une céramique polarisée dans cette direction et si la pression acoustique ne s'exerce que sur les faces planes de la céramique on dit que celle-ci fonctionne en mode 33. Pour garantir ce type de fonctionnement, on est obligé de soustraire la tranche de la céramique à la pression p au moyen d'une lame d'air continue, ce qui oblige à utiliser un boîtier 2 résistant lorsque l'hydrophone doit être plongé à des immersions importantes (plusieurs centaines de mètres). La masse de l'hydrophone est donc supérieure à celle d'un capteur, tel que celui présenté à la figure 1b, n'ayant pas cette contrainte et fonctionnant en mode hydrostatique.

Toutefois le facteur de mérite des matériaux piézo-électriques connus fonctionnant en mode hydrostatique est inférieur au facteur de mérite des matériaux fonctionnant dans des modes de compression ou de cisaillement privilégiés. On peut, pour pallier cet inconvénient, réaliser un hydrophone comportant deux matériaux piézo-électriques différents, voire plus, fonctionnant selon des modes différents. Par exemple, l'un 3 peut fonctionner en mode 33 et l'autre 4, en mode hydrostatique, comme le montre la figure 1c.

Ce type de montage permet de mieux résister à la pression hydrostatique et donc d'utiliser un boîtier d'hydrophone relativement léger. En outre, on peut, en appliquant, au moyen de tensions électriques, des champs électriques de polarisation distincts aux différents éléments piézo-électriques, les champs électriques pouvant eux-mêmes être appliqués dans des directions différentes, obtenir des sensibilités différentes pour les éléments de cet hydrophone, de façon à compenser par exemple des accélérations parasites, ou à doter l'hydrophone d'une directivité intrinsèque comme présenté sur la figure 1d. Sur cette dernière figure, un même matériau 5, composite en l'occurrence, est utilisé selon deux modes de fonctionnement.

On peut évidemment réaliser, en utilisant des procédés analogues, des hydrophones combinant les modes hydrostatiques, de compression, de cisaillement ou de flexion et faisant appel à des matériaux piézo-électriques fonctionnant suivant des modes différents.

La figure 1e représente ainsi un hydrophone constitué par des tubes 6, en matériau piézo-sensible, polarisables radialement au moyen d'une tension continue ou alternative et fonctionnant en cisaillement dans le mode 15, et par des disques 7, en matériau piézo-sensible, polarisables longitudinalement au moyen d'une tension continue ou alternative et fonctionnant en mode 33.

Le montage est symétrique de façon à compenser l'effet des vibrations lorsque les céramiques sont montées en hydrophones ou à les augmenter lorsque les céramiques sont montées en accéléromètres.

Le montage est symétrique de façon à compenser l'effet des vibrations lorsque les céramiques sont montées en hydrophones ou à les augmenter lorsque les céramiques sont montées en accéléromètres.

Les éléments 6 et 7 peuvent être réalisés avec des matériaux différents comme présenté sur la figure le ou avec un même matériau 8, en l'occurrence composite, comme montré sur la figure 1f.

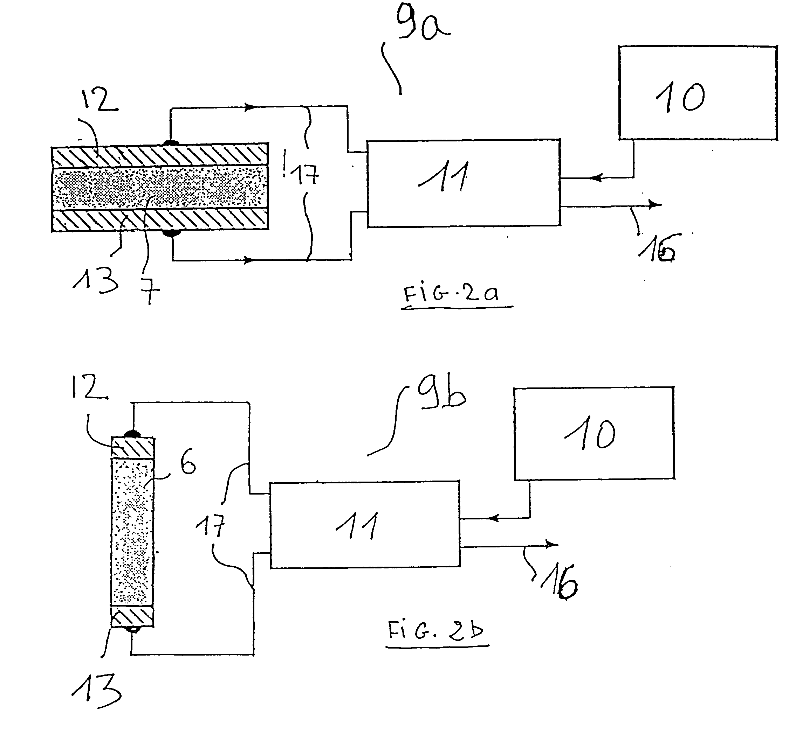

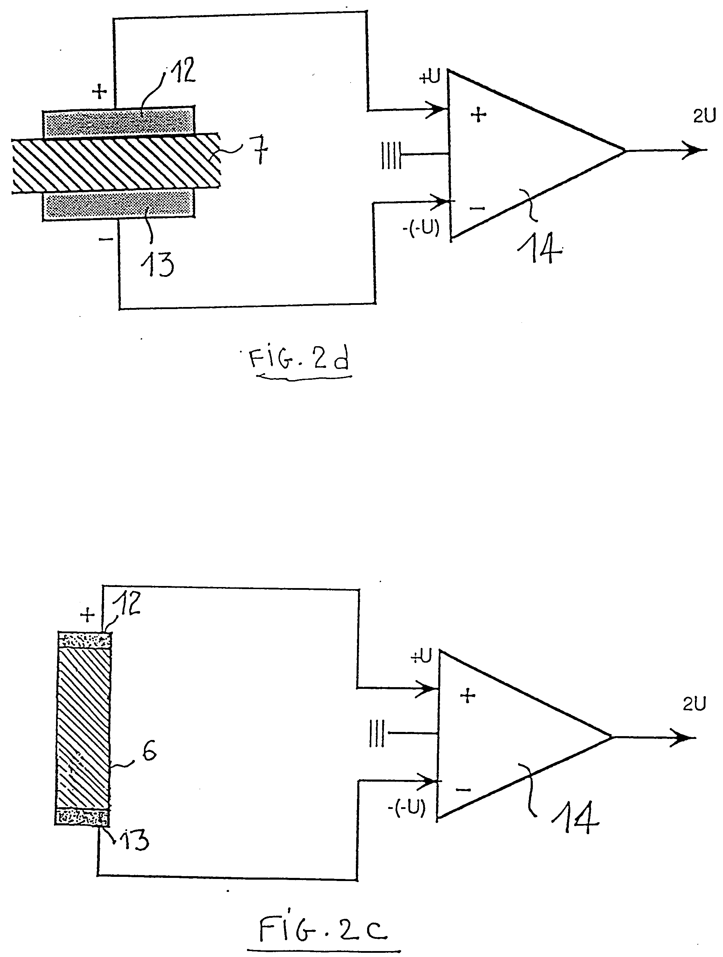

Les figures 2a et 2b montrent des moyens 9a, 9b d'application, respectivement aux tubes 6 et aux disques 7 montrés sur la figure 1f, d'une tension de polarisation U. Chacun de ces moyens 9a, 9b, comporte une source de tension 10, un amplificateur polarisateur 11 et des électrodes 12,13.

Chaque amplificateur comporte, notamment, un préamplificateur différentiel 14.

L'intérêt de ce type de montage est le suivant: les tubes 6 sont reliés à un préamplificateur différentiel comme montré sur la figure 2c, ce qui permet d'exploiter pleinement leur sensibilité hydrophonique. En revanche les disques 7, étant reliés à un préamplificateur différentiel comme indiqué sur la figure 2d, fonctionnent en accéléromètres. On a ainsi l'exemple d'un capteur doté de deux fonctions.

La polarisation variable appliquée aux éléments sensibles crée une troisième fonction qui est la correction des dissymétries des éléments sensibles (différences de sensibilités aux pressions acoustiques) comme mentionné précédemment et la correction des défauts qui pourraient apparaître dans ces matériaux au cours du temps. On peut ainsi obtenir une véritable fonction adaptative.

Là encore, on peut faire varier la polarisation à volonté et corriger ainsi les défauts de symétrie des éléments sensibles pour mieux compenser des accélérations parasites.

Les disques 7 et les tubes 6 montrés à la figure 1e, sont réalisés dans un matériau piézo-sensible constitué par des particules, telles que des fibres ou des poudres piézo-électriques, agglomérées sous pression et provenant, dans cette variante de réalisation, de deux matériaux piézo-électriques différents, l'un étant apte à fonctionner avec un bon rendement en mode 33 et l'autre, avec un bon rendement en mode 15. Les tailles des particules piézo-électriques dépendent, comme mentionné précédemment, des natures des matériaux et des procédés utilisés pour les obtenir. hydrophone, accélération pour un accéléromètre, etc.), et d'appliquer la tension de polarisation, provenant de la source 10, nécessaire au fonctionnement du capteur. On notera que le signal 16 est recueilli à la sortie d'un amplificateur polarisateur 11, qui permet de séparer la tension continue de polarisation, qui peut varier de quelques volts à 3 k V, et le signal basse tension délivré par le capteur.

Comme mentionné précédemment, un matériau piézo-sensible mis en oeuvre dans le cadre de l'invention peut être constitué d'une matrice de polymère ou de produit organique diélectrique, non piézo-électrique ou faiblement piézo-électrique, et de particules piézo-électriques.

Aussi, à titre d'exemple, pour la réalisation d'un hydrophone utilisant un tel matériau dans lequel les particules piézo-électriques sont des microcristaux de brushite fournie par la Société ALDRICH et la matrice, une résine silicone fournie par la Société RHODORSYL, le procédé de réalisation de l'ensemble matériau- électrodes peut être le suivant.

La résine silicone se présente sous la forme d'une résine A et d'un durcisseur B.

Quarante grammes de résine et quatre grammes de durcisseur sont mélangés au moyen d'un mélangeur et 2,2 grammes de microcristaux de brushite sont incorporés progressivement dans le mélange de pré polymère, et ce, jusqu'à homogénéisation complète. Le mélange est ensuite dégazé au moyen d'une pompe à vide.

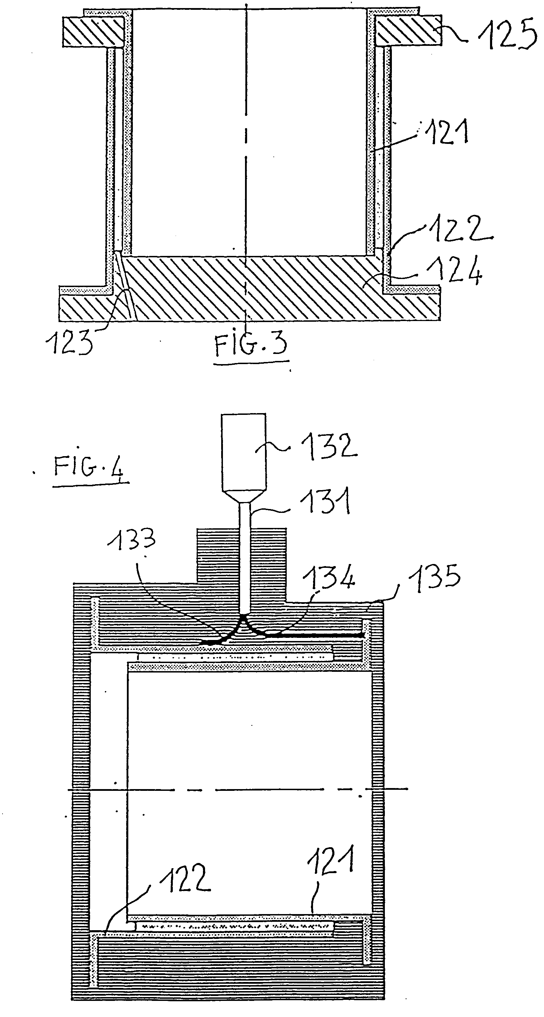

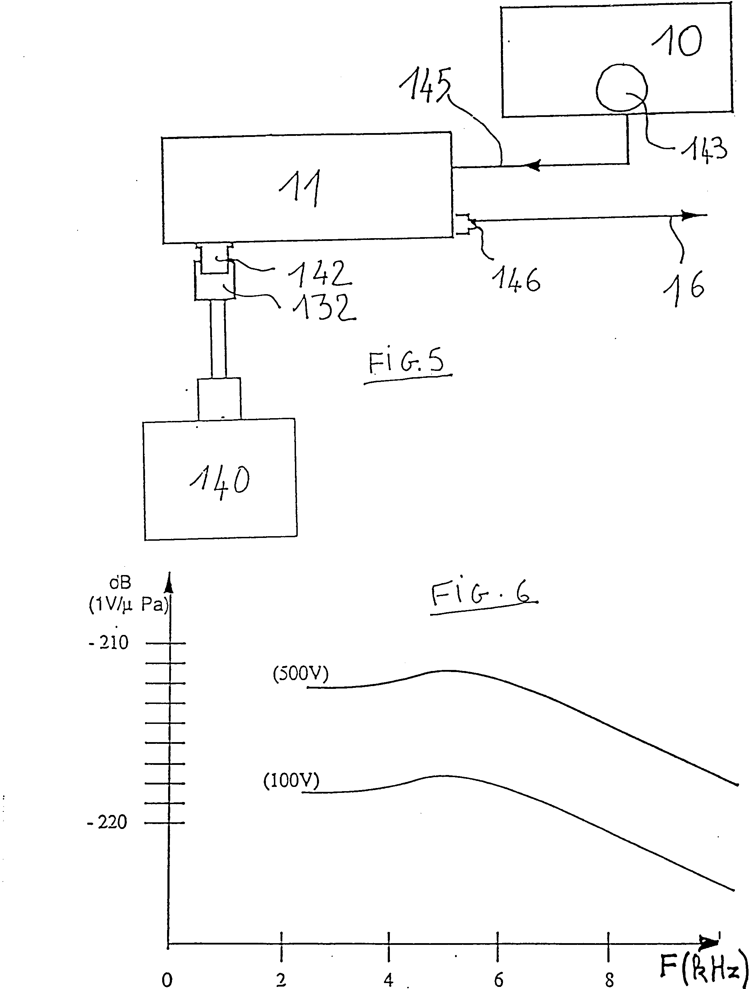

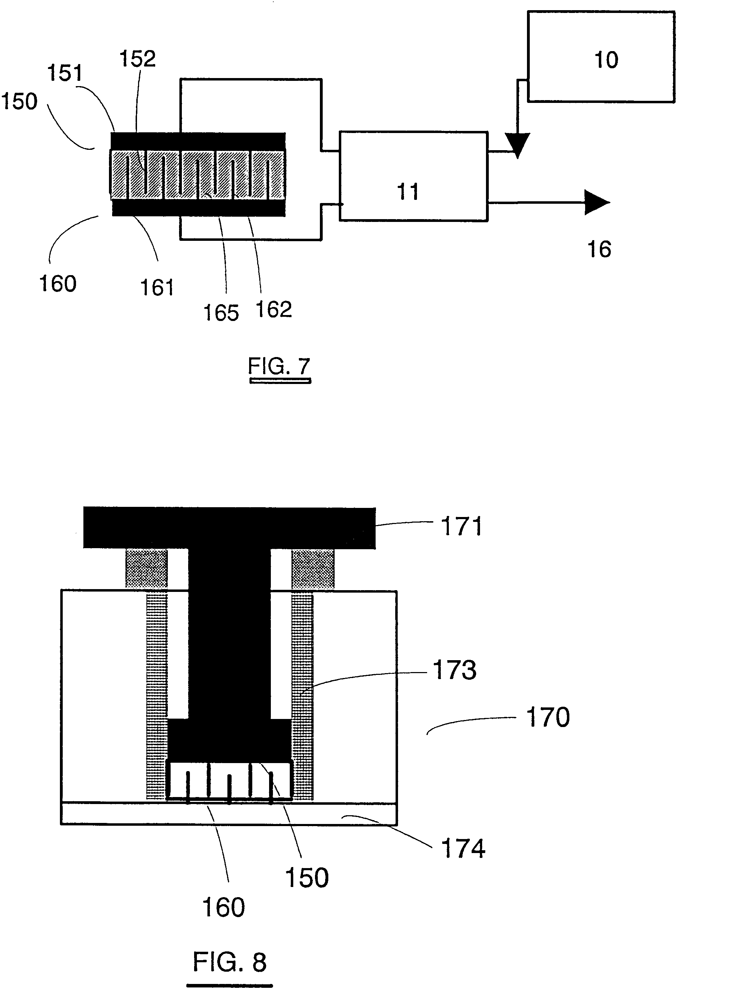

La résine étant toujours à l'état de pré polymère le mélange a été injecté, à travers un orifice d'injection 123, dans un moule en matière plastique et pourvu d'électrodes métalliques. Ce moule, montré à la figure 3, a la forme d'un cylindre. ll comprend deux parties 124,125 en Plexiglas et les électrodes sont constituées par deux cylindres métalliques 121 et 122 en bronze d'aluminium.

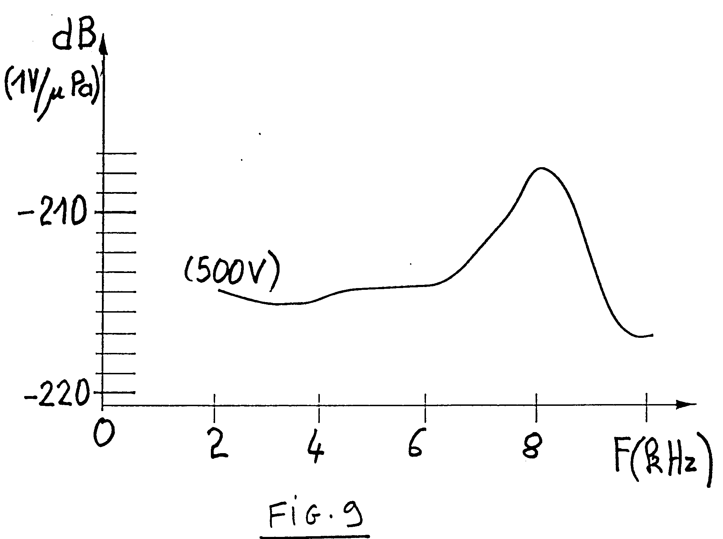

On laisse le mélange de résine et de microcristaux se polymériser pendant 48 heures. On rapporte sur les électrodes 121 et 122, comme montré sur la figure 4, un câble électrique coaxial 131,et équipé à son extrémité extérieure d'une prise 132. La tresse 133 du câble 131 est reliée à l'électrode externe 122. Le conducteur central 134 du câble 131 est relié à l'électrode interne 121. L'ensemble est placé dans un autre moule pour recevoir un enrobage extérieur 135 de résine polyuréthanne. Au cours de cette opération, une partie du câble 131 est surmoulée par l'enrobage 135. On obtient ainsi un capteur qui est utilisé comme hydrophone.

Comme montré sur la figure 5, la prise 132 est reliée à un amplificateur/polarisateur 11, se présentant sous la forme d'un coffret, qui est pourvu d'une embase coaxiale 142, et qui permet en même temps de recueillir le signal délivré par l'hydrophone et de le soumettre à une tension de polarisation continue.

Cette tension peut varier, en fonction de la sensibilité que l'on désire, de 0V à 2kV. Elle est réglée par un potentiomètre 143.

L'amplificateur/polarisateur 11 est relié à une source de tension continue 10 par l'intermédiaire d'un câble 145. Le câble 145 est connecté directement à l'intérieur du coffret et ce dernier est muni d'une prise 146, qui permet de récupérer le signal basse tension délivré par l'hydrophone et amplifié dans ce coffret.

La sensibilité de cet hydrophone a été évaluée dans une cuve acoustique. Les mesures ont été faites en utilisant un signal acoustique étalonné dans une bande de fréquence allant de 2,5 kHz à 10 kHz. En l'absence de tension de polarisation, l'hydrophone ne présente pas de sensibilité mesurable. On obtient une sensibilité mesurable à partir d'une tension de polarisation de 100V, et la sensibilité optimale est acquise pour une tension de polarisation de 500V. La figure 6 représente les courbes de sensibilité obtenues à 100V et à 500V dans la bande de fréquences précitée. La sensibilité est exprimée en décibels, la référence étant de 1V/µPa.

Comme mentionné précédemment, un matériau piézo-sensible mis en oeuvre dans le cadre de l'invention peut aussi être constitué d'un seul ou de plusieurs composants, tels que des microcristaux, des fibres ou des poudres, piézo-électriques, faiblement piézo-électriques ou non piézo-électriques et agglomérés par application d'une pression.

A titre d'exemple, pour la réalisation d'un hydrophone utilisant un matériau constitué par 18 grammes de microcristaux de brushite hydratée (CaHPO4) fournie par la Société ALDRICH, le procédé de réalisation de l'ensemble matériau- électrodes peut être le suivant.

Comme montré sur la figure 7, les électrodes 150,160 choisies dans cet exemple sont du type peigne c'est-à-dire du type de celles décrites dans la demande de brevet FR94.05991. Elles comprennent une plaque 151,161 de dimension 49mm x 49mm, et des lames 152,162 perpendiculaires à ladite plaque, de 1mm d'épaisseur et dont l'espacement, entre deux lames consécutives, est de 3 mm.

Les microcristaux de brushite hydratée 165 sont répartis entre les lames de l'électrode 150 puis, I'électrode 160 est positionnée de façon à ce que chaque lame 161 de cette dernière soit intercalée entre deux lames de l'électrode 150, et à ce que l'espace entre deux lames consécutives soit de 1mm.

Une pression de 20 MPa est ensuite appliquée pendant cinq minutes, à l'ensemble décrit ci-dessus, à l'aide de l'outillage 170 présenté à la figure 8.

Cet outillage comporte principalement un piston 171, deux entretoises 172, un corps de presse 173 et une semelle 174

Ladite pression peut éventuellement être appliquée jusqu'à l'obtention d'un agglomérat homogène, le contrôle de l'homogénéité pouvant être réalisé par un examen visuel et en mesurant les dimensions caractéristiques, au repos, du produit obtenu.

On rapporte ensuite sur les électrodes 121 et 122, comme montré sur la figure 4, un câble électrique coaxial 131,et équipé à son extrémité extérieure d'une prise 132. La tresse 133 du câble 131 est reliée à l'électrode externe 122. Le conducteur central 134 du câble 131 est relié à l'électrode interne 121. L'ensemble est placé dans un autre moule pour recevoir un enrobage extérieur 135 de résine polyuréthanne. Au cours de cette opération, une partie du câble 131 est surmoulée par l'enrobage 135. On obtient ainsi un capteur qui est utilisé comme hydrophone.

Comme montré sur la figure 5, la prise 132 est reliée à un amplificateur/polarisateur 11, se présentant sous la forme d'un coffret, qui est pourvu d'une embase coaxiale 142, et qui permet en même temps de recueillir le signal délivré par l'hydrophone et de le soumettre à une tension de polarisation continue.

Cette tension peut varier, en fonction de la sensibilité que l'on désire, de 0V à 2kV. Elle est réglée par un potentiomètre 143.

L'amplificateur/polarisateur 11 est relié à une source de tension continue 10 par l'intermédiaire d'un câble 145. Ce câble 145 est connecté directement à l'intérieur du coffret et ce dernier est muni d'une prise 146, qui permet de récupérer le signal basse tension délivré par l'hydrophone et amplifié dans ce coffret.

La sensibilité de cet hydrophone a été évaluée dans une cuve acoustique. Les mesures ont été faites en utilisant un signal acoustique étalonné dans une bande de fréquence allant de 2,5 kHz à 10kHz. En l'absence de tension de polarisation, l'hydrophone ne présente pas de sensibilité mesurable. On obtient une sensibilité mesurable à partir d'une tension de polarisation de 100V, et la sensibilité optimale est acquise pour une tension de polarisation de 500V. La figure 9 représente les courbes de sensibilité obtenues à 100V et à 500V dans la bande de fréquences précitée. La sensibilité est exprimée en décibels, la référence étant de 1V/µPa.

La valeur de la tension à partir de laquelle une sensibilité mesurable est obtenue dépend essentiellement du matériau utilisé et peut varier dans de larges proportions, la tension de polarisation correspondant à une sensibilité optimale pouvant être, dans certains cas, inférieure à 5V.

## Revendications

**1.** Dispositif piézo-sensible, caractérisé en ce qu'il comporte un ou plusieurs matériaux piézo-sensibles (1,3,5,6,7) et des moyens (9) permettant d'appliquer, à ce ou ces matériaux, une tension de polarisation U.

**2.** Dispositif selon la revendication 1, caractérisé en ce que les moyens (9) sont aptes à régler la valeur de la tension (U) de polarisation.

**3.** Dispositif selon l'une quelconque des revendications 1 et 2, caractérisé en ce que la tension (U) appliquée au matériau est continue.

**4.** Dispositif selon l'une quelconque des revendications 1 et 2, caractérisé en ce que la tension (U) appliquée au matériau est alternative.

**5.** Dispositif selon l'une quelconque des revendications 1 à 4, caractérisé en ce que les moyens (9) comportent une source (10) de tension, un amplificateur polarisateur (11) et des électrodes (12,13,150,160).

**6.** Dispositif selon la revendication 5, caractérisé en ce que lorsque le dispositif n'est pas piézo-électrique, lesdites électrodes (12,13,150,160) sont du type peigne.

**7.** Dispositif piézo-sensible selon l'une quelconque des revendications 1 à 6, caractérisé en ce que le matériau piézo-sensible (1,3,5,6,7) comporte des particules.

**8** Dispositif selon la revendication 7, caractérisé en ce que la taille des particules est comprise entre 5.10⁻⁹m et 5.10⁻³m.

**9** Dispositif selon l'une quelconque des revendications 7 et 8, caractérisé en ce que ces particules sont de taille sensiblement identique.

**10** Dispositif selon l'une quelconque des revendications 7 à 9, caractérisé en ce que ces particules sont issues d'au moins un matériau biologique.

**11** Dispositif selon la revendication 10, caractérisé en ce que les particules sont, en totalité ou en partie, choisies parmi des oligosaccharides, des homopolysaccharides, des hétéropolysaccharides, des glycosaminoglycanes, des protéoglycanes, des terpènes, des stéroïdes, des acides aminés, des oligopeptides et des polypeptides, des protéines, des nucléotides, des acides nucléiques, de l'urée ou des soies naturelles.

**12** Dispositif selon l'une quelconque des revendications 7 à 9, caractérisé en ce que les particules sont, en totalité ou en partie, des microcristaux ou des fibres de tartrate d'ammonium, de tartrate de potassium, de tartrate de diamine éthylène, de tartrate de dipotassium, de chlorate de sodium, de bromate de sodium, d'hexahydrate de sulfate de nickel, d'acide iodique, de benzophénone, de gallate de lithium hydraté, ou déshydraté, de polyvinyledifluoridène, de chrlorure de polyvinyle, de copolymère d'acétate de vinyle et de cyanide de vinylidène, de copolymère de vinylidène et de trifluoréthylène, du fluorure de polyvinyle, de nylon, de polyacrylonitrile, du polyparaxylylène, de polybichlorométhyloxétane, de polyamide aromatique, de polysulfone, de cyanoéthylcellulose, de monosaccharides, de disaccharides, de brushite, de monétite ou de sels d'acide carboxylique.

**13** Dispositif selon l'une quelconque des revendications 7 à 9, caractérisé en ce que les particules sont, en totalité ou en partie, issues, d'un polymère ou d'un produit organique diélectrique, non piézo-électrique ou faiblement piézo-électrique et choisi parmi les polystyrènes, polysulfones, polycarbonates, polypropylènes, polyéthylène, téréphtalates de polyéthylène, oxydes de polyphénylène, esters de polyacryalte, esters de polyméthacrylate, chlorures de polyvinyle, polyvinylidènes, polymères d'acrylonitrile, polymère de méthacrylonitriles, acétrates de polyvinyle, celluloïdes, acétates de cellulose, polyvinylepyrrolidones, polymères cellulosiques, phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, les copolymères de vinylidène et de trifluorèthylène, les elastomères de polyuréthanne ou les polyvinyles carbazone.

**14** Dispositif selon l'une quelconque des revendications 7 à 9, caractérisé en ce que les particules sont, en totalité ou en partie, issues, de feuilles ou de plaques, découpées, de matières plastiques piézo-électriques pré polarisées dans le sens de l'épaisseur ou non pré polarisées tels que du polyvinyledifluoridène, du chrlorure de polyvinyle, des copolymères d'acétate de vinyle et de cyanide de vinylidène, des copolymères de vinylidène et de trifluoréthylène, du fluorure de polyvinyle, des Nylon, des polyacrylonitriles, du polyparaxylylène, du polybichlorométhyloxétane, des polyamides aromatiques, des polysulfones ou des polypeptides synthétiques d'alkyglutamate et d'arylglutamate,

**15.** Dispositif piézo-sensible selon l'une quelconque des revendications 7 à 14, caractérisé en ce que le matériau piézo-sensible (1,3,5,6,7) est constitué d'un agglomérat de particules.

**16.** Dispositif piézo-sensible selon l'une quelconque des revendications 7 à 12, caractérisé en ce que le matériaux piézo-sensible (1,3,5,6,7) est constitué d'une matrice de polymère ou de produit organique diélectrique, non piézo-électrique ou faiblement piézo-électrique, et de particules piézo-électriques.

**17.** Dispositif selon la revendication 16, caractérisé en ce que la matrice de polymère ou le produit organique diélectrique, non piézo-électrique ou faiblement piézo-électrique est choisi parmi les polystyrènes, polysulfones, polycarbonates, polypropylènes, polyéthylène, téréphtalates de polyéthylène, oxydes de polyphénylène, les elastomères de polyuréthanne, les polyvinylecarbazols et les fluorures de polyvinylidène, les esters de polyacryalte ou de de polyméthacrylate, les chlorures de polyvinyle, polyvinylidènes, les polymères d'acrylonitrile ou de méthacrylonitriles, les acétates de polyvinyle, celluloïdes, acétates de cellulose, polyvinylepyrrolidones, polymères cellulosiques, phénol-formaldéhydes, les résines phénols-furfural, les polymères solubles de polyimide, les résines époxydes, les résines polymérisables, les caoutchoucs naturels, les caoutchoucs synthétiques, les résines silicones, les colles de carbinol ou d'os, les polystyrols, les gommes laque, ou les copolymères de vinylidène et de trifluorèthylène.

**18** Dispositif selon l'une quelconque des revendications 1 à 17, caractérisé en ce qu'il est utilisé dans un capteur.

**19** Capteur utilisant au moins deux dispositifs selon l'une quelconque des revendications 1 à 17, caractérisé en ce que les matériaux piézo-sensibles de ces dispositifs fonctionnent selon des modes différents.

**20.** Capteur selon la revendication 19, caractérisé en ce les les champs de polarisation continue ou alternative appliqués pour faire apparaître la sensibilité desdits matériaux piézo-sensibles et correspondant aux tensions de polarisation continue ou alternative, ont des directions identiques.

**21** Capteur selon la revendication 19, caractérisé en ce les les champs de polarisation continue ou alternative appliqués pour faire apparaître la sensibilité desdits matériaux piézo-sensibles et correspondant aux tensions de polarisation continue ou alternative, ont des directions différentes.
